# EUROPEAN PATENT APPLICATION

(11) **EP 4 462 466 A2**
(43) Date of publication of application: **13.11.2024**
(21) Application number: 24174924.1
(22) Date of filing: 08.05.2024
(51) Int. Cl.: H01L 21/20

(54) **SUPERLATTICE EPITAXIAL STRUCTURE WITH VARYING LATTICE PARAMETER DIFFERENCES**

(30) Priority: 10.05.2023 US 202318315398
(71) Applicant: Infineon Technologies Canada Inc., Kanata, Ontario K2V 1C8 (CA)
(72) Inventor: CANIZARES, Claudio Andres, Ottawa, K2V 1C8 (CA)
(74) Representative: Kraus & Lederer PartGmbB

(57) **Abstract**

A superlattice epitaxial structure epitaxially grown on a substrate. The superlattice epitaxial structure includes epitaxial layers composing multiple layer sequences. Each of the multiple layer sequences includes a corresponding lower layer and a corresponding upper layer epitaxially grown on the corresponding lower layer. The lattice parameter of the epitaxial layers alternate lower and higher (or higher and lower) moving up through the superlattice epitaxial structure. The difference in lattice parameters in the neighboring lower and higher epitaxial layers may also vary moving up through the epitaxial structure. Thus, by varying the difference between the lattice parameters, the strain endured at that level may be engineered with the effect of increasing the electrical resistance seen vertically through the superlattice epitaxial structure, thus allowing the structure to be thinner and/or operate with higher voltages.

## Description

### BACKGROUND

Electronic circuits typically include transistors, which function as electronic switches that regulate or control current flow in portions of the circuit. One type of transistor is a field-effect transistor in which a voltage is applied to a gate terminal to turn the transistor on and off. A semiconductor channel region is disposed between the drain terminal and the source terminal. When the transistor is on, current flows through the semiconductor channel region between the source terminal and the drain terminal. When the transistor is off, lesser or no current flows through the semiconductor channel region between the source terminal and the drain terminal. The gate terminal is disposed over the semiconductor channel region between the source terminal and the drain terminal. Voltage on the gate terminal generates a field that affects whether the semiconductor channel region conducts current - hence the term "field-effect transistor".

Silicon has traditionally been used to fabricate transistors. However, wider bandgap semiconductor material may be used to fabricate transistors that conduct higher power and operate at higher efficiency than silicon transistors. Silicon carbide (SiC), Aluminum Nitride (AlN), Zinc Oxide (ZnO), and Gallium Nitride (GaN) are each examples of wide bandgap semiconductor materials that can be used in power electronics. However, it is not feasible to use a substrate of these materials since such is expensive, and much harder to fabricate than a silicon substrate. Accordingly, wide bandgap semiconductor materials are typically epitaxially grown on a silicon substrate taking advantage of the manufacturability and availability of silicon substrates in combination with the wide bandgap of the epitaxially grown material to facilitate high power electronics.

However, each semiconductor material has a crystal structure that has a certain distance between repeating lattice points. Such a characteristic distance in a semiconductor crystal is often referred to as a "lattice constant" or a "lattice parameter". Because the distance changes as the crystal structure expands and contracts with temperature, the term "lattice parameter" is more frequently used herein to avoid confusion in the fact that a lattice "constant" of a given semiconductor material can indeed change with temperature. However, across all operational temperatures, the lattice parameter of silicon may be quite different than the lattice parameter of a wider bandgap semiconductor material.

For example, when GaN is grown on a silicon substrate, there is a significant lattice mismatch between the two materials, which can lead to defects and dislocations in the GaN layer. These defects can degrade the performance of GaN-based devices, such as high-electron-mobility transistors (HEMTs) and light-emitting diodes (LEDs). To address this issue, a superlattice structure is conventionally used as a buffer layer between the silicon substrate and the GaN layer. The superlattice buffer layer consists of alternating layers of two different materials with different bandgaps, which can be used to overcome the lattice mismatch between these two materials, resulting in a more structurally stable device.

The subject matter claimed herein is not limited to embodiments that solve any disadvantages or that operate only in environments such as those described above. Rather, this background is only provided to illustrate one exemplary technology area where some embodiments described herein may be practiced.

### BRIEF SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

According to an embodiment, a superlattice epitaxial structure as defined in claim 1 is provided. The dependent claims define further embodiments.

Embodiments described herein relate to a superlattice epitaxial structure epitaxially grown on a substrate. The superlattice epitaxial structure includes epitaxial layers composing multiple layer sequences. Each of the multiple layer sequences includes a corresponding lower layer and a corresponding upper layer epitaxially grown on the corresponding lower layer. The lattice parameter of the lower epitaxial layer alternates lower and higher (or higher and lower) moving up through the superlattice epitaxial structure. The difference in lattice parameters in the neighboring lower and higher layers may also vary moving up through the epitaxial structure. Thus, by varying the difference between the lattice parameters, the strain endured at that level may be engineered. For instance, the engineering may be such that misfit dislocations are created further down in the superlattice structure as compared to what would occur had the difference in lattice parameters remained relatively the same moving up through the superlattice epitaxial structure. These misfit dislocations usually end in threading dislocations which can move up the material during epitaxial growth. Since the threading dislocations can be conductive, this has the effect of allowing the upper part of the superlattice structure to act more as an insulator, thereby allowing the superlattice structure to be thinner and/or allowing for an increase in operating voltages.

As an example only, there may be repeating patterns of two different semiconductor materials, where perhaps the composition percentage of one (or both) of the two different layers is permitted to vary moving up through the superlattice epitaxial structure. For instance, there may be repeating patterns of AlN and AlGaN, where the percentage of Al composition of the AlGaN layer decreases (and thereby the Ga composition increases) for each successive AlGaN layer. As an example only, the composition may shift from 100 percent AlN to 100 percent GaN in a linear fashion moving up through the superlattice epitaxial structure. Doing so would indeed have the effect of biasing the misfit dislocations to be further down in the superlattice structure.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims, or may be learned by the practice of the invention as set forth hereinafter.

### BRIEF DESCRIPTION OF THE DRAWINGS

In order to describe the manner in which the above-recited and other advantages and features can be obtained, a more particular description of the subject matter briefly described above will be rendered by reference to specific embodiments which are illustrated in the appended drawings. Understanding that these drawings depict only typical embodiments and are not therefore to be considered to be limiting in scope, embodiments will be described and explained with additional specificity and detail through the use of the accompanying drawings in which:
Figure 1 illustrates a crystal cell view of a gallium nitride (GaN) crystal cell superimposed on a silicon crystal cell, each crystal cell oriented so that a hexagonally closed packed array of atoms defining each cell faces the viewer;
Figure 2A illustrates an example structure in which an upper semiconductor layer is deposited (e.g., through epitaxial growth) on a lower semiconductor layer.
Figure 2B shows a side view of the upper semiconductor layer of Figure 2A deposited on the lower semiconductor layer of Figure 2A.
Figures 3A and 3B are similar to that of Figures 2A and 2B, respectively, except to illustrate that the opposite effect may also occur when a layer of higher lattice parameter semiconductor material is grown on a layer of lower lattice parameter semiconductor material.
Figure 3B illustrates a side view that shows that these compressive forces tend the structure to be convex.
Figure 4 illustrates a side view of an example structure in which an upper semiconductor layer of a lower lattice parameter is deposited on a lower semiconductor layer of a higher lattice parameter.
Figure 5 illustrates an actual Transmission Electron Microscopy (TEM) image of a layer of GaN grown on a layer of AlN, which was grown on a Si wafer.
Figure 6 illustrates a time progress diagram showing the bending of a wafer as the wafer is processed to have multiple epitaxial layers.
Figure 7A illustrates a side view of a single layer sequence that includes a lower semiconductor layer and an upper semiconductor layer.
Figure 7B is a composition diagram in which vertical position in the superlattice epitaxial structure is represented on the vertical axis, and composition in percentage of Al in the respective layer at that vertical position is represented on the horizontal axis.
Figures 8A and 8B illustrate an example superlattice epitaxial structure in which the lower semiconductor layer is composed of AlGaN where the Al percentage increases linearly from 0 percent to 100 percent moving up through the superlattice epitaxial structure, and in which the upper semiconductor layer is composed of AlGaN where the Al percentage decreases linearly from 100 percent to 0 percent moving up through the superlattice epitaxial structure; and
Figure 9A and 9B illustrate an example superlattice epitaxial structure in which the lower semiconductor layer has M% AlGaN (where M is 28 in this specific example), and where the upper semiconductor layer that is composed of AlGaN where the Al percentage decreases in exponential fashion linearly from 100 percent to 5 percent moving up through the superlattice epitaxial structure.

### DETAILED DESCRIPTION

Embodiments described herein relate to a superlattice epitaxial structure epitaxially grown on a substrate. The superlattice epitaxial structure includes epitaxial layers composing multiple layer sequences. Each of the multiple layer sequences includes a corresponding lower layer and a corresponding upper layer epitaxially grown on the corresponding lower layer. The lattice parameter of the lower epitaxial layer alternates lower and higher (or higher and lower) moving up through the superlattice epitaxial structure. The difference in lattice parameters in the neighboring lower and higher layers may also vary moving up through the epitaxial structure. Thus, by varying the difference between the lattice parameters, the strain endured at that level may be engineered. For instance, the engineering may be such that misfit dislocations are created further down in the superlattice structure as compared to what would occur had the difference in lattice parameters remained relatively the same moving up through the superlattice epitaxial structure. These misfit dislocations usually end in threading dislocations which can move up the material during epitaxial growth. Since the threading dislocations can be conductive, this has the effect of allowing the upper part of the superlattice structure to act more as an insulator, thereby allowing the superlattice structure to be thinner and/or allowing for an increase in operating voltages.

As an example only, there may be repeating patterns of two different semiconductor materials, where perhaps the composition percentage of one (or both) of the two different layers is permitted to vary moving up through the superlattice epitaxial structure. For instance, there may be repeating patterns of AlN and AlGaN, where the percentage of Al composition of the AlGaN layer decreases (and thereby the Ga composition increases) for each successive AlGaN layer. As an example only, the composition may shift from 100 percent AlN to 100 percent GaN in a linear fashion moving up through the superlattice epitaxial structure. Doing so would indeed have the effect of biasing the misfit dislocations to be further down in the superlattice structure.

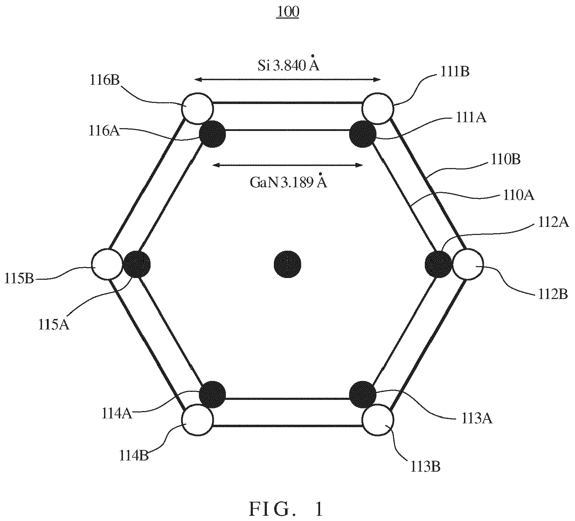

Figure 1 illustrates a crystal cell view 100 of a gallium nitride (GaN) crystal cell 110A superimposed on a silicon crystal cell 110B, each crystal cell oriented so that a hexagonally closed packed array of atoms defining each cell faces the viewer. If a layer of GaN were to be grown directly on a layer of Si in the <111> facial orientation, then the layers would each be formed of cells in the hexagonally closed pack array at the interface between the two layers. In the <111> orientation, silicon crystals have a hexagonal structure with a lattice parameter of 3.840 Angstroms on each hexagonal side. On the other hand, GaN crystals have a hexagonal structure with a lattice parameter of 3.189 Angstroms when oriented along the hexagonally closed pack array. This lattice parameter difference is extreme. Accordingly, it is not standard practice to grow GaN layers directly on a Si substrate due to the extreme lattice parameter mismatch. Nevertheless, a discussion of what would happen if a GaN layer were to be grown directly on a Si substrate would be helpful to understand stresses induced by lattice mismatch between two different semiconductor materials.

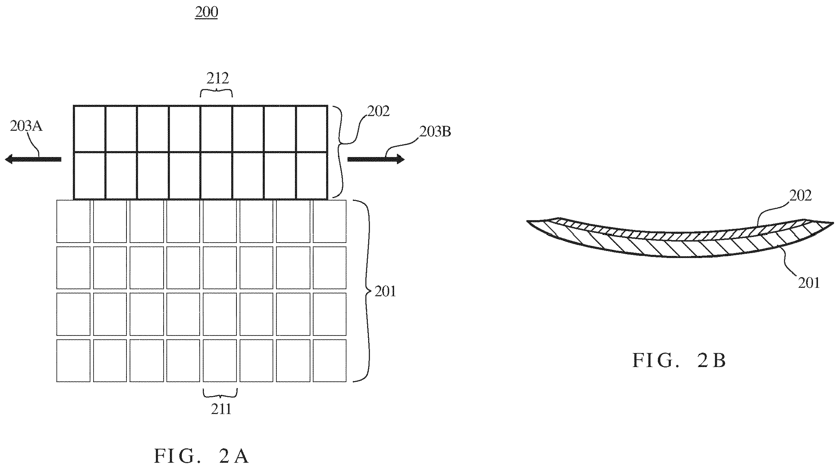

Each point in the lattice structure is an atom of the crystal, whereas each link between points is a bond between neighboring atoms in the crystal. If GaN were indeed grown on Si, each Ga or N atom in the GaN layer would bond with a corresponding Si atom in the Si layer. This will cause the GaN layer to endure a tensile stress with a corresponding compressive stress on the Si layer. Accordingly, the Ga or N atom of point 111A will bond with the Si atom of point 111B. Likewise, the Ga or N atoms of points 112A through 116A will bond with the Si atoms of points 112B through 116B, respectively. Thus, when one semiconductor material is grown on other in the hexagonal orientation, there will be strain and stresses in the interface between the two semiconductor materials. This has implications when a semiconductor layer is deposited on another semiconductor layer in the context of semiconductor fabrication, as will now be described with respect to Figures 2A through 3B.

Figure 2A illustrates an example structure 200 in which an upper semiconductor layer 202 is deposited (e.g., through epitaxial growth) on a lower semiconductor layer 201. As an example, the lower semiconductor layer 201 may be the upper surface of a wafer (such as a silicon wafer), and the upper semiconductor layer 202 may be a layer of wide bandgap semiconductor material epitaxially grown on that wafer.

The grid patterns of each of the upper semiconductor layer 202 and the lower semiconductor layer 201 represent the characteristic repeating pattern in each respective semiconductor material. The grid pattern for the upper semiconductor layer 202 shows a horizontal distance 212 between vertical lines, the horizontal distance representing the lattice parameter along the horizontal plane. On the other hand, the grid pattern for the lower semiconductor layer 201 has a greater horizontal distance 211 between vertical lines, representing that the lower semiconductor layer 201 has a larger lattice parameter than the upper semiconductor layer 202. Molecules from one crystalline material will try to bond with molecules in the other crystalline material. Accordingly, this will cause the upper semiconductor layer 202 to have tensile stress as represented by arrows 203A and 203B (and there will be corresponding compressive stress in the lower semiconductor layer 201).

Figure 2B shows a side view of the upper semiconductor layer 202 deposited on the lower semiconductor layer 201. For example, if the lower semiconductor layer 201 was a silicon wafer substrate, Figure 2B shows a side view of the wafer. Figure 2B shows in exaggerated form that the tensile strain of the upper semiconductor layer will tend the entire wafer to be concave in the direction of deposition (e.g., upwards in Figure 2B). Since the silicon wafer is relatively thick compared to an epitaxial layer, the concave bending will be quite slight. As previously mentioned, the lower semiconductor layer 201 may be a silicon wafer, and the upper semiconductor layer 202 may be a layer of wide bandgap semiconductor material epitaxially grown on the top surface of that wafer. However, the principles described with respect to Figures 2A and 2B may be applied whenever a crystalline material of a smaller lattice parameter is grown on a crystalline material of a larger lattice parameter.

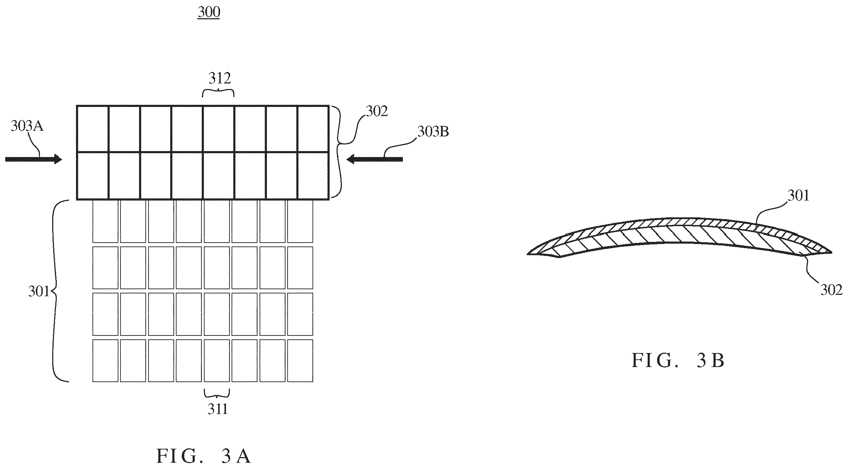

Figures 3A and 3B are similar to that of Figures 2A and 2B, respectively, except to illustrate that the opposite effect may also occur when a layer of larger lattice parameter semiconductor material is grown on a layer of smaller lattice parameter semiconductor material. For instance, Figure 3A illustrates that an example structure 300 in which an upper semiconductor layer 302 that grown on the lower semiconductor layer 301. The higher semiconductor layer 302 here has a larger lattice parameter (represented by distance 312) than the lattice parameter (represented by distance 311) of the lower semiconductor layer 301. Accordingly, the upper semiconductor layer 302 experiences compressive stress as represented by arrows 303A and 303B as the atoms in the respective lattices try to bond (and there will be corresponding tensile stresses experienced in the lower semiconductor layer 301). Figure 3B illustrates a side view that shows that these compressive forces tend the structure to be convex.

Accordingly, as shown above with respect to Figures 2A through 3B, the wafer can bend due to strain caused when semiconductor materials of dissimilar lattice parameters are joined via epitaxial growth. In cases where many layers of different materials are epitaxially grown, each new layer will experience compressive stress or tensile stress applying respective tensile or compressive stress to the structures on which the new epitaxial layer is grown.

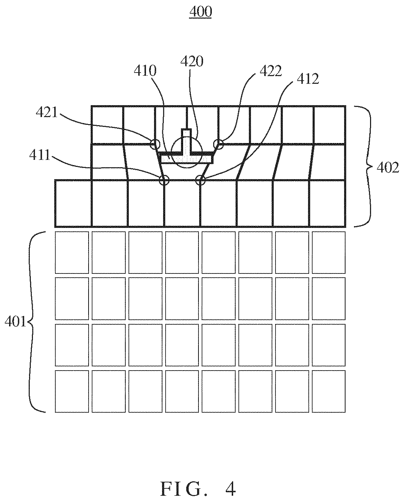

There will inevitably be misfit dislocations whenever a crystalline material is epitaxially grown on top of a crystalline material of a different lattice parameter. For instance, Figure 4 illustrates a side view of an example structure 400 in which an upper semiconductor layer 402 of a smaller lattice parameter is deposited on a lower semiconductor layer 401 of a larger lattice parameter. In this case, atoms of the upper layer 402 will stretch to form a bond with a corresponding atom in the lower semiconductor layer 401, but only up to a limit. At some point, an atom (e.g., see point 420) in the upper semiconductor layer 402 will not form a bond with atoms immediately below. Instead, its neighboring atoms 421 and 422 of the upper semiconductor 402 will form bonds with atoms 411 and 412 immediately below. This results in misfit dislocation 410. Misfit dislocations will continue laterally along the crystal until terminated by the edge of the material, or more frequently, by threading dislocations that extend upward during growth.

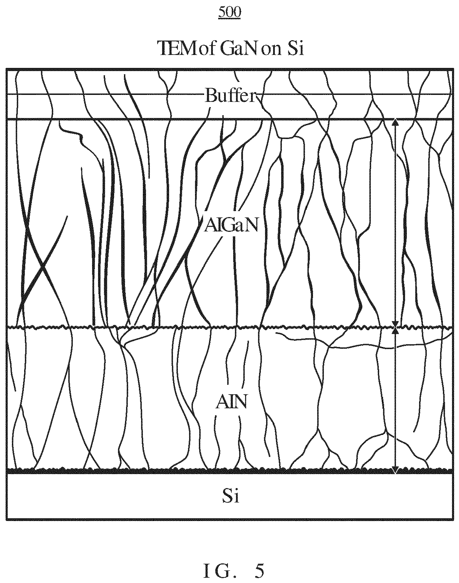

The presence of the misfit dislocation 410 encourages the production of threading dislocations which extend upward in the material. Figure 5 illustrates an actual Transmission Electron Microscopy (TEM) image 500 of a layer of GaN grown on a layer of AlN, which was grown on a Si wafer. The darker regions represent dislocations caused by lattice mismatch. Horizontal channels are misfit dislocations which propagate vertical channels of threading dislocations. Since the threading dislocations are more conductive, this causes the superlattice structure to have less electrical resistance in the vertical direction. This can cause undesirable leakage current from the active layers to the substrate, thereby harming performance of the transistors.

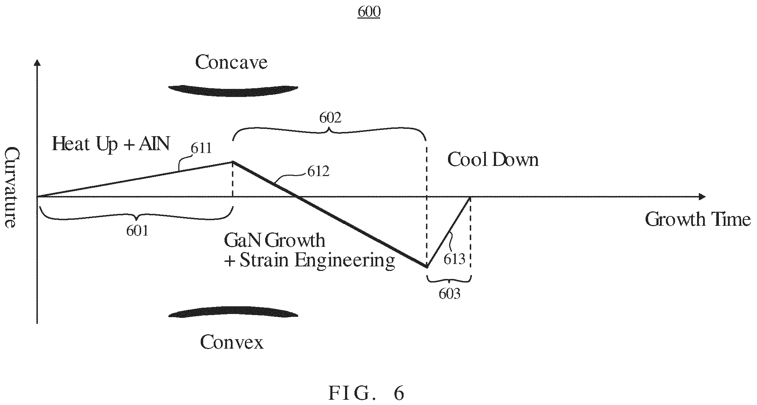

Furthermore, as each epitaxial layer is formed, the wafer will become more convex or more concave depending on whether the new epitaxial layer endures tensile stress or compressive stress due to lattice parameter mismatch with the neighboring lower layer. Figure 6 illustrates a time progress diagram 600 showing the bending of a wafer as the wafer is processed to have multiple epitaxial layers. In this particular time progress diagram 600, both temperature and the material type being epitaxial grown have an impact on the curvature of the wafer. In this particular example, a layer of AlN is epitaxially grown on an Si wafer in time period 601. Thereafter, in time period 602, a superlattice epitaxial structure is epitaxially grown on the AlN, which includes GaN and potentially also AlN in various combinations. Thereafter, in time period 603, the wafer is cooled down to normal ambient temperature.

As represented by line 611, during time period 601, the wafer becomes steadily more concave due to the lower lattice parameter of AlN compared to Si, and further due to the higher temperatures required to epitaxially grow AlN on Si. On the other hand, during time period 603, as represented by line 613, the cooling down of the wafer causes a convex wafer to become less convex to the point where the curvature is sufficiently low that the wafer is a suitably flat foundation to fabricate further structures on the superlattice structure. The goal of time period 602 is to grow the superlattice structure with sufficient strain engineering that by the end of the time period 602, the wafer has sufficient curvature that the cooling (during time period 603) will result in a sufficiently flat wafer to form further structures thereon (such as active regions of electrical circuitry).

Though lines 611 through 613 are shown as straight lines, the bending of the wafer does not typically vary linearly with time. However, the lines 611 through 613 are presented merely to demonstrate the larger principle that the superlattice structure can be formed via strain engineering such that the wafer is sufficiently convex that subsequent cooling will result in a relatively flat wafer. In order to bias misfit dislocations so that they are created more towards the lower part of the superlattice epitaxial structure, the line 612 should be a curve that declines more steeply at the start of time period 602, and have a much more slight slope at the end of time period 602.

In accordance with the principles described herein, a superlattice epitaxial structure is constructed such that the difference in the lattice parameter of neighboring semiconductor layers changes moving up through the superlattice epitaxial structure. This helps so that the line 612 may assume such a curve and thus tend the misfit dislocations to occur lower in the superlattice epitaxial structure.

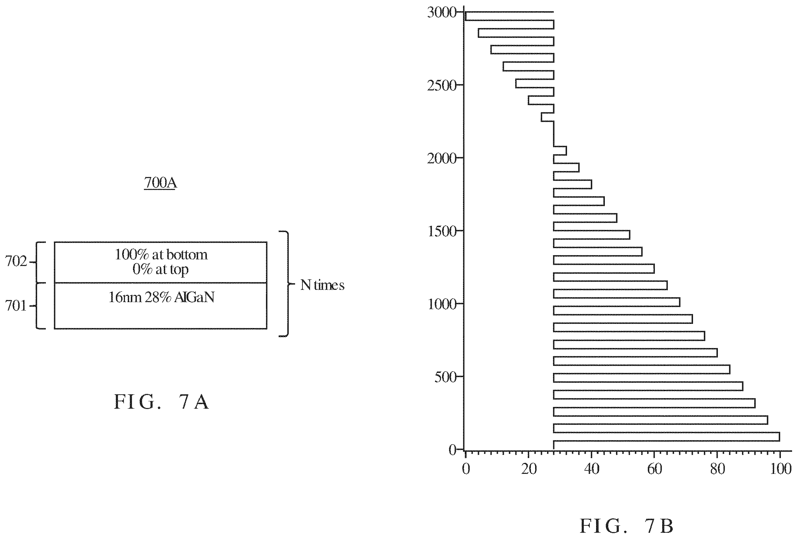

Figures 7A and 7B collectively illustrate a specific example in which the superlattice epitaxial structure comprises many repeating layer sequences. Figure 7A illustrates a side view of a single layer sequence 700A that includes a lower layer 701 and an upper layer 702. The layer sequence of Figure 7A may be repeated N times moving up through the superlattice epitaxial structure, where N is some positive integer. Thus, as the repeating layer sequences are stacked, the stack includes layers alternating between a lower layer 701 and an upper layer 702. However, in each layer sequence subsequently deposited, a composition of one or both the lower layer 701 or the upper layer 702 may change. If done for at least some of the layer sequences, this allows the lattice parameter difference (i.e., the lattice mismatch) between the respective lower and upper layers to change moving up through the layer sequences in the superlattice epitaxial structure.

Figure 7B is a composition diagram in which vertical position in the superlattice epitaxial structure is represented on the vertical axis, and composition in percentage of Al in the respective layer at that vertical position is represented on the horizontal axis. In this particular example, the composition of the lower layer 701 remains the same. Specifically, in this example, the composition of the lower layer 701 is 28% AlGaN. Thus, the layer is 28% Al, and 72% Ga.

However, in this example, the upper layer 702 is AlGaN, but with its Al content changed linearly from 100% to 0%. Accordingly, moving up vertically in Figure 7B, one finds 26 oscillations in Al content between 28 percent (which each correspond to a lower layer 701), and some other value (which each correspond to the upper layer 702).

In Figure 7B, to avoid the lines become too close together and difficult to read, there are only 26 such oscillations representing 26 layer sequences. However, N is typically much larger (e.g., 93). However, Figure 7B does illustrated the general principle. That is, in the lowest layer sequence, the upper layer 702 is 100% AlN. However, in the highest layer sequence, the upper layer 702 is 100% GaN. More generally speaking, X percent up through the superlattice epitaxial structure, the composition of the upper semiconductor layer 702 is approximately (100-X) percent AlN and X percent GaN. Such a gradual change in the composition of the upper semiconductor layer 702 will cause misfit dislocations to gather further down in the superlattice epitaxial structure as compared to having the upper semiconductor layer 702 have a constant composition for each layer sequence.

Stated more broadly, the first composite material for each lower semiconductor layer 701 may be a composite of AlN and GaN which is composed of M% AlN (where M is a number between 0 and 100), and the second composite material for each upper semiconductor layer may also be a composite of AlN and GaN containing N% AlN (where N is also a number between 0 and 100, but is different than M).

However, the materials of the lower semiconductor layer 701 and the upper semiconductor layer 702 may be any semiconductor material. As only an example, the first composite material for each lower semiconductor layer 701 may be a composite of InAs and GaAs which is composed of M% InAs (where M is a number between 0 and 100), and the second composite material for each upper semiconductor layer may also be a composite of InAs and GaAs containing N% InAs (where N is also a number between 0 and 100, but is different than M).

However, the semiconductor material of the lower semiconductor layer 701 may be any semiconductor material that where the first semiconductor material has M% of a particular component element, and the second semiconductor material is of that same composition but with N% of a particular component element. Stated, even more broadly, the lower semiconductor material and the upper semiconductor material need not even be composed of the same composition. For example, one layer might be InGaN, and another layer may be AlGaN. As yet another example, one layer might be AlInGaN, and the other layer might be AlGaN or InGaN. However, if the layers are the same composition but with different percentages of component elements, the fabrication will be easier since only element proportions would need to be changed, which can typically be done with a single epitaxial deposition machine.

The more general principles described herein are not at all limited to the embodiment described with respect to Figures 7A and 7B. As an example, in Figure 7A, the lower layer 701 is described as being 28% AlGaN, and the upper semiconductor layer 702 has been described as AlGaN, but with its Al content changed linearly from 100% to 0%. In other words, M is fixed at 28, and N is permitted to vary linearly from 100 to 0 moving up through the superlattice epitaxial structure. However, M may be fixed at any number, and/or N may vary linearly but not span the entire range from 100 to 0. For instance, N may vary linearly from some percentage less than 100 (e.g., 80) percent, and/or vary linearly ending at some percentage greater than 0 (e.g., 20) percentage.

As described above, it is the component percentage N of the upper semiconductor layer 702 that is permitted to vary, whereas the component percent M of the lower semiconductor layer 701 stays constant. Alternatively, the component percentage N of the upper semiconductor layer 702 stays constant, whereas the component percentage M of the lower semiconductor layer 701 may be permitted to vary. Alternatively, both the component percentage N of the upper semiconductor layer 702 and the component percentage M of the lower semiconductor layer 701 is permitted to vary.

Where permitted to vary, the component percentages M and N may change monotonically or non-monotonically. Monotonic change means that the component percentage either only increases moving up through the superlattice epitaxial structure, or only decreases moving up through the superlattice epitaxial structure. Furthermore, where permitted to vary, the component percentages M and N may change linearly or non-linearly. Where both M and N are permitted to change, they may either both change linearly, both change non-linearly, or one can change linearly and the other non-linearly.

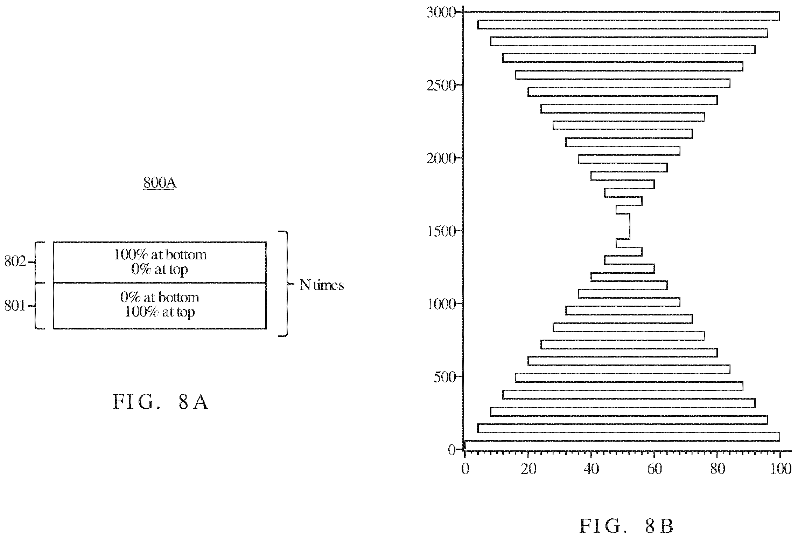

Figures 8A and 8B illustrate an example superlattice epitaxial structure in which the lower semiconductor layer 801 is composed of AlGaN where the Al percentage increases linearly from 0 percent to 100 percent moving up through the superlattice epitaxial structure. Furthermore, the upper semiconductor layer 802 that is composed of AlGaN where the Al percentage decreases linearly from 100 percent to 0 percent moving up through the superlattice epitaxial structure.

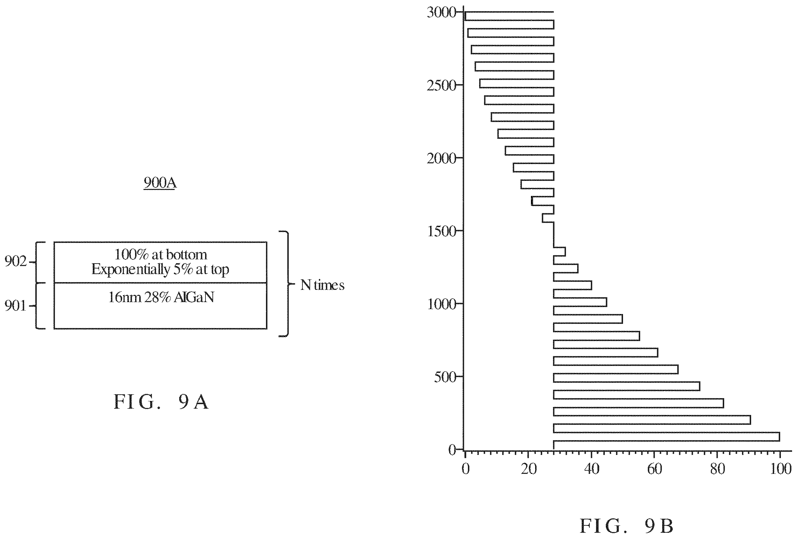

Figure 9A and 9B illustrate an example superlattice epitaxial structure in which the lower semiconductor layer 701 has M% AlGaN (where M is 28 in this specific example), and where the upper semiconductor layer 702 that is composed of AlGaN where the Al percentage decreases in exponentially from 100 percent to 5 percent moving up through the superlattice epitaxial structure.

Each of these examples will result in misfit dislocations being generated further down in the superlattice epitaxial structure than if the component percentages of the upper and lower semiconductor layers remains constant. However, such may also be achieved in many circumstances where the difference in the lattice parameters of the upper and lower semiconductor layers is permitted to change moving up through the superlattice epitaxial structure. Furthermore, in this description, one layer sequence changes from another in the composition and/or material of one or both of the lower semiconductor layer or the upper semiconductor layer. However, generation of misfit dislocations may also be achieved by changing the thickness of one or both of the upper or lower semiconductor layers in successive layer sequences. Finally, although the principles described herein are described in the context of each layer sequence having two component layers, the principles described herein may also be applied where there are more than two component layers in a layer sequence. Even in that case, however, one of the component layers may be regarded as a lower semiconductor layer that neighbors and upper semiconductor layer.

Thus, a superlattice epitaxial structure has been described that allows flexibility in changing the layer sequences moving up through the superlattice epitaxial structure such that misfit dislocations are further down in the superlattice epitaxial structure as compared to not varying the layer sequences. Accordingly, the electrical resistance of the superlattice epitaxial structure in the direction perpendicular to the direction of epitaxial growth may be increased, thereby reducing current leakage from active areas to the substrate. This allows the superlattice epitaxial structure to be thinner, and/or facilitate growth of high power electronic devices that may operate at higher voltages.

### Literal Support Section

Clause 1. A superlattice epitaxial structure epitaxially grown on a substrate, the superlattice epitaxial structure comprising a plurality of epitaxial layers composed of multiple layer sequences, each of the multiple layer sequences including a corresponding lower layer and a corresponding upper layer epitaxially grown on the corresponding lower layer, wherein for the first layer sequence in the multiple layer sequences, the lower layer has a lattice parameter that has a magnitude polarity as compared to the substrate and the higher layer of the first layer sequence, wherein for additional layer sequences in the multiple layer sequences, the lower layer of the corresponding layer sequence has the magnitude polarity as compared to the higher layer of a prior layer sequence and as compared to the higher layer of the corresponding layer sequence, a difference between a lattice parameter of the lower layer and the higher layer of one layer sequence being different than a lattice parameter of the lower layer and the higher layer of another layer sequence.

Clause 2. The superlattice epitaxial structure in accordance with Clause 1, the lower layers being of a different thickness for each of at least some of the multiple layer sequences.

Clause 3. The superlattice epitaxial structure in accordance with Clause 1, the higher layers being of a different thickness for each of at least some of the multiple layer sequences.

Clause 4. The superlattice epitaxial structure in accordance with Clause 1, the lower layer for each of the multiple layer sequences being composed of a first composite material for each of the multiple layer sequences, the higher layer for each of the multiple layer sequences being composed of a second composite material for each of the multiple layer sequences.

Clause 5. The superlattice epitaxial structure in accordance with Clause 4, the first composite material for each lower layer being a composite of AlN and GaN with a composition of M% AlN (wherein M is a number being 0 and 100), and a second composite material for each higher layer being is a composite of AlN and GaN with a composition of N% AlN, (wherein N is a number between 0 and 100), where for each of the multiple layer sequences, wherein M and N are different for each of at least some of the multiple layer sequences.

Clause 6. The superlattice epitaxial structure in accordance with Clause 4, a first composite material for each lower layer being a composite of InN and GaN with a composition of M% InN (wherein M is a number being 0 and 100), and the second composite material for each higher layer being is a composite of InN and GaN with a composition of N% InN, (wherein N is a number between 0 and 100), wherein M and N are different for each of at least some of the multiple layer sequences.

Clause 7. The superlattice epitaxial structure in accordance with Clause 4, a component percentage of the first composite material changing for each successive lower layer in the multiple layer sequences.

Clause 8. The superlattice epitaxial structure in accordance with Clause 7, the component percentage of the first component material changing linearly for each successive lower layer in the multiple layer sequences.

Clause 9. The superlattice epitaxial structure in accordance with Clause 7, the component percentage of the first component material changing non-linearly for each successive lower layer in the multiple layer sequences.

Clause 10. The superlattice epitaxial structure in accordance with Clause 7, the component percentage of the first composite material changing monotonically for each successive lower layer in the multiple layer sequences.

Clause 11. The superlattice epitaxial structure in accordance with Clause 7, a component percentage of the second composite material changing for each successive lower layer in the multiple layer sequences.

Clause 12. The superlattice epitaxial structure in accordance with Clause 11, the component percentage of the second component material changing linearly for each successive higher layer in the multiple layer sequences.

Clause 13. The superlattice epitaxial structure in accordance with Clause 11, the component percentage of the second component material changing non-linearly for each successive higher layer in the multiple layer sequences.

Clause 14. The superlattice epitaxial structure in accordance with Clause 11, the component percentage of the second composite material changing monotonically for each successive higher layer in the multiple layer sequences.

Clause 15. The superlattice epitaxial structure in accordance with Clause 4, a component percentage of the second composite material changing for each successive lower layer in the multiple layer sequences.

Clause 16. The superlattice epitaxial structure in accordance with Clause 15, the component percentage of the second component material changing linearly for each successive higher layer in the multiple layer sequences.

Clause 17. The superlattice epitaxial structure in accordance with Clause 15, the component percentage of the second component material changing non-linearly for each successive higher layer in the multiple layer sequences.

Clause 18. The superlattice epitaxial structure in accordance Clause Claim 15, the component percentage of the second composite material changing monotonically for each successive higher layer in the multiple layer sequences.

Although the subject matter has been described in language specific to structural features and/or methodological acts, it is to be understood that the subject matter defined in the appended claims is not necessarily limited to the described features or acts described above, or the order of the acts described above. Rather, the described features and acts are disclosed as example forms of implementing the claims.

The present disclosure may be embodied in other specific forms without departing from its essential characteristics. The described embodiments are to be considered in all respects only as illustrative and not restrictive. All changes which come within the meaning and range of equivalency of the claims are to be embraced within their scope.

When introducing elements in the appended claims, the articles "a," "an," "the," and "said" are intended to mean there are one or more of the elements. The terms "comprising," "including," and "having" are intended to be inclusive and mean that there may be additional elements other than the listed elements.

## Claims

1. A superlattice epitaxial structure epitaxially grown on a substrate, the superlattice epitaxial structure comprising a plurality of epitaxial layers composed of multiple layer sequences, each of the multiple layer sequences including a corresponding lower layer and a corresponding upper layer epitaxially grown on the corresponding lower layer,
wherein for the first layer sequence in the multiple layer sequences, the lower layer has a lattice parameter that has a magnitude polarity as compared to the substrate and the higher layer of the first layer sequence,
wherein for additional layer sequences in the multiple layer sequences, the lower layer of the corresponding layer sequence has the magnitude polarity as compared to the higher layer of a prior layer sequence and as compared to the higher layer of the corresponding layer sequence,
a difference between a lattice parameter of the lower layer and the higher layer of one layer sequence being different than a lattice parameter of the lower layer and the higher layer of another layer sequence.

2. The superlattice epitaxial structure in accordance with Claim 1, the lower layers and/or the higher layers being of a different thickness for each of at least some of the multiple layer sequences.

3. The superlattice epitaxial structure in accordance with Claim 1 or 2, the lower layer for each of the multiple layer sequences being composed of a first composite material for each of the multiple layer sequences, the higher layer for each of the multiple layer sequences being composed of a second composite material for each of the multiple layer sequences.

4. The superlattice epitaxial structure in accordance with Claim 3, the first composite material for each lower layer being a composite of AlN and GaN with a composition of M% AlN (wherein M is a number being 0 and 100), and a second composite material for each higher layer being is a composite of AlN and GaN with a composition of N% AlN, (wherein N is a number between 0 and 100), where for each of the multiple layer sequences, wherein M and N are different for each of at least some of the multiple layer sequences.

5. The superlattice epitaxial structure in accordance with Claim 3, a first composite material for each lower layer being a composite of InN and GaN with a composition of M% InN (wherein M is a number being 0 and 100), and the second composite material for each higher layer being is a composite of InN and GaN with a composition of N% InN, (wherein N is a number between 0 and 100), wherein M and N are different for each of at least some of the multiple layer sequences.

6. The superlattice epitaxial structure in accordance with any one of Claims 3 to 5, a component percentage of the first composite material changing for each successive lower layer in the multiple layer sequences.

7. The superlattice epitaxial structure in accordance with Claim 6, the component percentage of the first component material changing linearly for each successive lower layer in the multiple layer sequences.

8. The superlattice epitaxial structure in accordance with Claim 6, the component percentage of the first component material changing non-linearly for each successive lower layer in the multiple layer sequences.

9. The superlattice epitaxial structure in accordance with any one of Claims 6 to 8, the component percentage of the first composite material changing monotonically for each successive lower layer in the multiple layer sequences.

10. The superlattice epitaxial structure in accordance with any one of Claims 3 to 9, a component percentage of the second composite material changing for each successive lower layer in the multiple layer sequences.

11. The superlattice epitaxial structure in accordance with Claim 10, the component percentage of the second component material changing linearly for each successive higher layer in the multiple layer sequences.

12. The superlattice epitaxial structure in accordance with Claim 10, the component percentage of the second component material changing non-linearly for each successive higher layer in the multiple layer sequences.

13. The superlattice epitaxial structure in accordance with any one of Claims 10 to 12, the component percentage of the second composite material changing monotonically for each successive higher layer in the multiple layer sequences.
